# FASCICULE DE BREVET EUROPEEN

(11) **EP 2 977 988 B1**
(45) Date de publication et mention de la délivrance du brevet: **19.06.2019**
(21) Numéro de dépôt: 15306182.5
(22) Date de dépôt: 21.07.2015
(51) Int. Cl.: G11C 13/00

(54) **MÉMOIRE NON VOLATILE À RÉSISTANCE PROGRAMMABLE**
NICHT-FLÜCHTIGER SPEICHER MIT PROGRAMMIERBAREM WIDERSTAND
NON-VOLATILE MEMORY WITH PROGRAMMABLE RESISTANCE

(30) Priorité: 25.07.2014 FR 1457180
(43) Date de publication de la demande: 27.01.2016
(73) Titulaire: COMMISSARIAT À L'ÉNERGIE ATOMIQUE ET AUX ÉNERGIES ALTERNATIVES, 75015 Paris (FR)
(72) Inventeur: Benoist, Thomas-Medhi, 38000 Grenoble (FR); Ayari, Haithem, 13001 Marseille (FR); Giraud, Bastien, 38340 Voreppe (FR); Makosiej, Adam, 38000 Grenoble (FR); Maneglia, Yves, 38600 Fontaine (FR); Onkaraiah, Santhosh, 13004 Marseille (FR); Portal, Jean-Michel, 13119 Saint-Savournin (FR); Thomas, Olivier, 38420 Revel (FR)
(74) Mandataire: Cabinet Beaumont

(56) Documents cités:
- US-A1- 2010 238 711
- US-A1- 2010 238 719
- US-A1- 2014 050 009

## Description

### Domaine

La présente demande concerne le domaine des circuits électroniques de façon générale, et vise plus particulièrement le domaine des mémoires non volatiles à résistance programmable, couramment appelées mémoires résistives.

### Exposé de l'art antérieur

Les mémoires résistives tirent profit de la capacité qu'ont certains matériaux à changer de résistivité électrique de façon réversible et non volatile sous l'effet d'une polarisation. De façon classique, une mémoire résistive comprend une matrice de cellules élémentaires de stockage comportant chacune un élément de stockage et un ou plusieurs transistors d'accès. L'élément de stockage est essentiellement constitué par deux régions conductrices ou électrodes, séparées par une couche résistive à résistance programmable. L'application d'une tension convenablement choisie entre les deux électrodes permet de modifier la résistance de la couche résistive. Des données peuvent ainsi être enregistrées dans les cellules sur la base de valeurs de résistance. A titre d'exemple, chaque cellule élémentaire de stockage est adaptée à stocker un bit de données. Un élément de stockage dans un état faiblement résistif peut par exemple correspondre à la valeur binaire 1, et un élément de stockage dans un état fortement résistif peut correspondre à la valeur binaire 0. Les mémoires résistives existantes présentent divers inconvénients, notamment des problèmes de fiabilité dans le temps, liés au fait que les niveaux de tension appliqués pour programmer les cellules élémentaires peuvent être relativement élevés. Il serait souhaitable de pouvoir disposer d'une mémoire résistive palliant tout ou partie de ces inconvénients.

Les documents US2010/238719 et US2014/050009 décrivent des exemples de mémoires magnéto-résistives.

### Résumé

L'invention est définie par les revendications.

Ainsi, un mode de réalisation prévoit une mémoire non volatile comprenant une pluralité de cellules élémentaires disposées en lignes et en colonnes, chaque cellule comportant : un premier transistor d'accès reliant des premier et deuxième noeuds de la cellule ; un deuxième transistor d'accès reliant le premier noeud à un troisième noeud de la cellule ; et un unique élément de stockage à résistance programmable connecté au premier noeud, cet élément de stockage reliant le premier noeud à un quatrième noeud de la cellule, dans laquelle, dans chaque ligne, les cellules ont leurs quatrièmes noeuds connectés par une première piste conductrice de connexion en ligne, et les grilles de leurs premiers transistors connectées par une deuxième piste conductrice de connexion en ligne, et dans laquelle, dans chaque colonne, les cellules ont leurs deuxièmes noeuds connectés par une première piste conductrice de connexion en colonne, et leurs troisièmes noeuds connectés par une deuxième piste conductrice de connexion en colonne, la mémoire comportant en outre un circuit de commande connecté aux cellules par l'intermédiaire des premières et deuxièmes pistes conductrices de connexion en ligne et des premières et deuxièmes pistes conductrices de connexion en colonne, ce circuit étant adapté à : lors d'une phase de programmation d'une cellule dans un premier état, appliquer une tension d'une première polarité aux bornes de l'élément de stockage de la cellule par l'intermédiaire des quatrième et troisième noeuds et du deuxième transistor de la cellule.

Selon un mode de réalisation, le circuit de commande est en outre adapté, lors d'une phase de lecture d'une cellule à : précharger le deuxième noeud de la cellule à un premier potentiel ; appliquer un deuxième potentiel différent du premier potentiel sur le quatrième noeud de la cellule ; commander à l'état passant le premier transistor ; puis mesurer une variation du potentiel du deuxième noeud par rapport au premier potentiel.

Selon un mode de réalisation, dans chaque cellule, la grille du deuxième transistor est connectée à un noeud d'application d'un potentiel fixe.

Selon un mode de réalisation, dans chaque cellule, les premier et deuxième transistors sont des transistors MOS de types de conductivité opposés.

Selon un mode de réalisation, dans chaque cellule : la différence entre le potentiel appliqué sur le premier noeud lors la phase de programmation de la cellule dans le premier état et le potentiel appliqué sur le premier noeud lors la phase de programmation de la cellule dans le deuxième état est supérieure à la tension grille-source ou grille-drain maximale que peuvent supporter sans dégradation les premier et deuxième transistor ; et les potentiels appliqués sur les grilles des premier et deuxième transistors lors des phases de programmation de la cellule dans les premier et deuxième états sont de niveau intermédiaire entre le potentiel appliqué sur le premier noeud lors la phase de programmation de la cellule dans le premier état et le potentiel appliqué sur le premier noeud lors la phase de programmation de la cellule dans le deuxième état.

Selon un mode de réalisation, dans chaque cellule, le premier transistor est un transistor MOS à canal N, et le deuxième transistor est un transistor MOS à canal P.

Selon un mode de réalisation, chaque cellule comprend en outre : un troisième transistor d'accès reliant un cinquième noeud à un sixième noeud de la cellule ; un quatrième transistor d'accès reliant le cinquième noeud au troisième noeud de la cellule ; et un unique élément de stockage à résistance programmable connecté au cinquième noeud, cet élément de stockage reliant le cinquième noeud au quatrième noeud de la cellule.

Selon un mode de réalisation, dans chaque cellule, la grille du troisième transistor est connectée à la grille du premier transistor, et la grille du quatrième transistor est connectée à la grille du deuxième transistor.

Selon un mode de réalisation, dans chaque cellule, les premier et troisième transistors sont de même type de conductivité, et les deuxième et quatrième transistors sont de même type de conductivité.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique illustrant un exemple d'une cellule élémentaire d'une mémoire résistive ;
la figure 2 est un chronogramme illustrant un exemple d'un procédé de commande d'une cellule mémoire du type décrit en relation avec la figure 1 ;
la figure 3 est un schéma électrique illustrant un exemple d'un mode de réalisation d'une cellule élémentaire d'une mémoire résistive ;
la figure 4 est un chronogramme illustrant un exemple d'un procédé de commande d'une cellule mémoire du type décrit en relation avec la figure 3 ;
la figure 5 est un schéma électrique illustrant une variante de réalisation d'une cellule élémentaire d'une mémoire résistive ;
la figure 6 est un schéma électrique illustrant une autre variante de réalisation d'une cellule élémentaire d'une mémoire résistive ;
la figure 7 est un schéma électrique illustrant une autre variante de réalisation d'une cellule élémentaire d'une mémoire résistive ;
la figure 8 est un schéma électrique illustrant un exemple d'un mode de réalisation d'une mémoire résistive ;
la figure 9 est une vue en coupe illustrant de façon schématique un exemple de réalisation d'une cellule élémentaire d'une mémoire résistive ; et
la figure 10 est un schéma électrique partiel d'un exemple de réalisation d'un circuit de commande d'une cellule mémoire du type décrit en relation avec les figures 3 à 8.

### Description détaillée

Par souci de clarté, de mêmes éléments ont été désignés par de mêmes références aux différentes figures et, de plus, les diverses figures ne sont pas tracées à l'échelle. Par ailleurs, dans la suite de la description, sauf indication contraire, les termes "approximativement", "sensiblement", "environ", "quasiment" et "de l'ordre de", signifient "à 20% près".

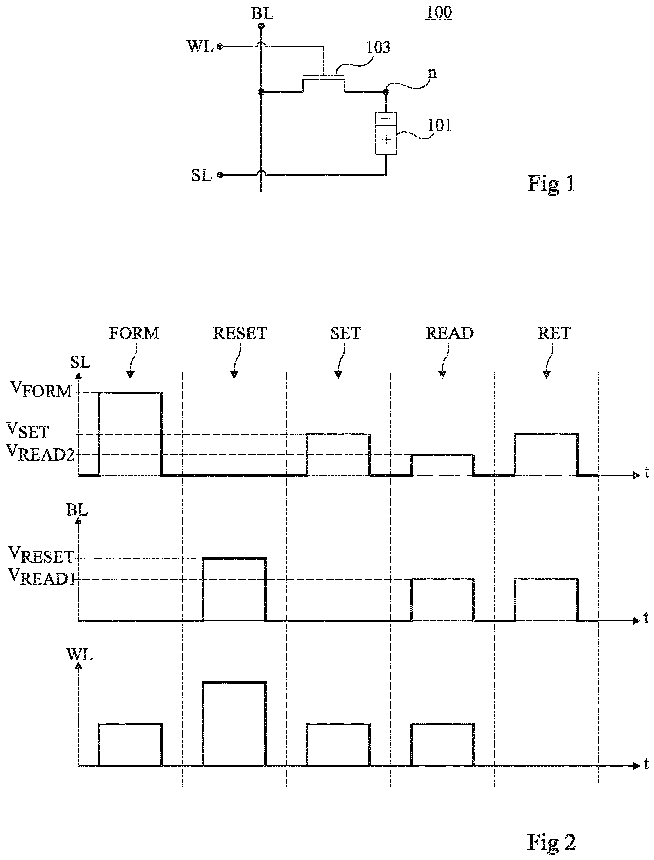

La figure 1 est un schéma électrique d'un exemple d'une cellule élémentaire 100 d'une mémoire résistive. La cellule 100 comprend un élément de stockage 101 à résistance programmable. L'élément de stockage 101 comprend par exemple deux régions conductrices ou électrodes, séparées par une couche à résistance programmable. La cellule 100 comprend en outre un transistor d'accès 103, un transistor MOS à canal N dans l'exemple représenté, connecté en série avec l'élément de stockage 101 entre des noeuds BL et SL de la cellule. Dans cet exemple, les électrodes de l'élément de stockage 101 sont connectées respectivement au noeud SL et à un noeud intermédiaire n de la cellule, et les noeuds de conduction (source, drain) du transistor 103 sont connectés respectivement au noeud n et au noeud BL de la cellule. Chaque cellule comprend en outre un noeud WL connecté à la grille du transistor 103. On notera que l'élément de stockage 101 est un dipôle asymétrique, c'est-à-dire que son comportement dépend de la polarité de la tension appliquée entre ses électrodes. En effet, la programmation de l'élément 101 dans un état faiblement résistif est obtenue par application d'une tension de programmation d'une certaine polarité entre ses électrodes, alors que la programmation de l'élément 101 dans un état fortement résistif est obtenue par application d'une tension de programmation de polarité opposée entre ses électrodes. Dans cet exemple, on considère que l'élément de stockage 101 de la cellule 100 est connecté de telle façon que la programmation de l'élément 101 dans un état faiblement résistif soit obtenue par application d'une tension positive entre les noeuds SL et n de la cellule, et que la programmation de l'élément 101 dans un état fortement résistif soit obtenue par application d'une tension négative entre les noeuds SL et n de la cellule.

La figure 2 est un chronogramme illustrant un exemple d'un procédé de commande de la cellule 100 de la figure 1. Plus particulièrement, la figure 2 illustre l'évolution, en fonction du temps, des potentiels appliqués sur les noeuds SL, BL et WL de la cellule 100 lors de différentes phases de commande de la cellule.

Lors de la première utilisation de la cellule 100 après fabrication, l'élément de stockage 101 de la cellule est dans un état très fortement résistif, et doit être initialisé. Pour cela, une tension positive relativement élevée peut être appliquée entre les noeuds SL et n de la cellule, afin de créer un chemin conducteur ou faiblement résistif dans la couche résistive de l'élément de stockage 103. Comme cela sera expliqué plus en détail ci-après, ce chemin pourra ensuite être "effacé" puis "recréé" un grand nombre de fois par application de tensions de programmation respectivement négative et positive, de plus faible amplitude que la tension d'initialisation, lors d'étapes d'écriture dans la cellule.

Dans cet exemple, lors d'une phase d'initialisation (FORM) de la cellule 100, le noeud BL est mis à un potentiel de référence ou masse, par exemple de 0 V, et le noeud SL est mis à un potentiel V_{FORM} positif (c'est-à-dire supérieur au potentiel de référence). Le potentiel V_{FORM} est par exemple supérieur à un potentiel d'alimentation haute V_{DD} de la puce contenant la mémoire. A titre d'exemple, le potentiel V_{FORM} est de l'ordre de 2*V_{DD}, le potentiel V_{DD} étant par exemple un potentiel d'alimentation haute adapté à l'alimentation de circuits intégrés réalisés en technologie CMOS comportant des transistors de dimensions identiques ou similaires à celles du transistor 103, par exemple un potentiel de l'ordre de 1,2 V. Lors de la phase d'initialisation, le transistor d'accès 103 de la cellule est rendu passant par application d'un potentiel positif inférieur au potentiel V_{FORM}, par exemple de l'ordre de V_{DD}, sur le noeud WL.

A l'issue de la phase d'initialisation, l'élément de stockage 101 de la cellule 100 est dans un état dit faiblement résistif. L'élément 101 peut être reprogrammé dans un état plus fortement résistif. Pour cela, une tension de programmation négative peut être appliquée entre les noeuds SL et n de la cellule 100, entrainant la suppression du chemin faiblement résistif préalablement formé dans la couche résistive de l'élément 101.

Dans cet exemple, lors d'une phase (RESET) de reprogrammation de la cellule 100 dans un état fortement résistif, le noeud SL est mis à la masse, le noeud BL est mis à un potentiel positif V_{RESET} inférieur au potentiel V_{FORM}, par exemple de l'ordre de 1,5*V_{DD}, et le transistor d'accès 103 de la cellule est rendu passant par application d'un potentiel positif supérieur au potentiel V_{RESET} sur le noeud WL, par exemple un potentiel de l'ordre de 2*V_{DD}. Les potentiels sont choisis de façon que le transistor 103 laisse passer un courant suffisant pour permettre le changement d'état de l'élément de stockage 101.

Après une étape (RESET) de reprogrammation de la cellule 100 dans un état fortement résistif, l'élément de stockage 101 de la cellule peut à nouveau être reprogrammé dans un état faiblement résistif. Pour cela, une tension positive de reprogrammation peut être appliquée entre les noeuds SL et n de la cellule 100, entrainant la reformation d'un chemin faiblement résistif dans la couche résistive de l'élément 101.

Dans cet exemple, lors d'une phase (SET) de reprogrammation de la cellule 100 dans un état faiblement résistif, le noeud BL est mis à la masse, le noeud SL est mis à un potentiel positif V_{SET}, par exemple inférieur au potentiel V_{RESET}, par exemple de l'ordre de V_{DD}, et le transistor d'accès 103 de la cellule est rendu passant par application d'un potentiel positif, par exemple de l'ordre de V_{DD}, sur le noeud WL.

Lire la valeur stockée dans la cellule 100 consiste à déterminer si l'élément de stockage 101 de la cellule est dans un état faiblement résistif ou dans un état fortement résistif.

Dans cet exemple, lors d'une phase (READ) de lecture de la cellule 100, le noeud BL est préchargé à un potentiel positif V_{READ1}, par exemple de l'ordre de V_{DD}, puis laissé flottant, et le noeud SL est mis à un potentiel V_{READ2} inférieur au potentiel V_{READ1}, par exemple à un potentiel de l'ordre de V_{DD}/2. Le transistor d'accès 103 de la cellule est alors rendu passant par application d'un potentiel positif, par exemple de l'ordre de V_{DD}, sur le noeud WL. Après un temps de décharge pendant lequel le transistor d'accès 103 est à l'état passant, le potentiel du noeud BL est comparé à un potentiel de référence par un circuit de lecture non représenté. Si le potentiel du noeud BL est supérieur au potentiel de référence, la cellule est considérée comme étant dans un état fortement résistif, et si le potentiel du noeud BL est inférieur au potentiel de référence, la cellule est considérée comme étant dans un état faiblement résistif.

Dans cet exemple, pendant des phases (RET) de veille ou de rétention d'information, c'est-à-dire lorsque la mémoire est alimentée mais qu'aucune opération d'initialisation, d'écriture ou de lecture n'est effectuée dans la cellule, les noeuds BL et SL sont mis à un même potentiel, par exemple un potentiel positif de l'ordre de V_{DD}, et le transistor 103 est bloqué par l'application d'un potentiel adapté, par exemple de 0 V, sur le noeud WL.

Un inconvénient de la cellule mémoire 100 décrite en relation avec les figures 1 et 2 est lié notamment aux niveaux de tension à appliquer pour programmer la cellule dans un état faiblement résistif (FORM et SET) ou dans un état fortement résistif (RESET). En particulier, lors des phases de RESET, un potentiel V_{RESET} relativement élevé (supérieur au potentiel V_{DD}) est appliqué sur le noeud BL, et un potentiel encore plus élevé est appliqué sur le noeud WL pour rendre le transistor 103 passant. Il en résulte une certaine complexité des circuits de commande de la mémoire pour appliquer des niveaux de tension adaptés sur les noeuds BL et WL des cellules. De plus, l'oxyde de grille du transistor 103 peut être soumis à des tensions relativement importantes (supérieures à V_{DD}), ce qui peut entrainer une dégradation relativement rapide de ce transistor.

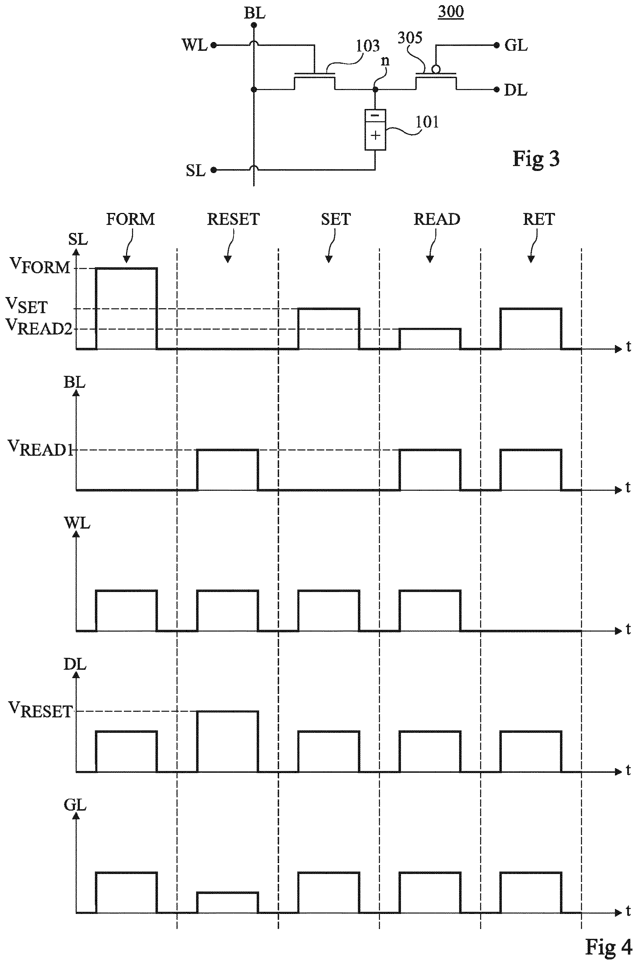

La figure 3 est un schéma électrique illustrant un exemple d'un mode de réalisation d'une cellule élémentaire 300 d'une mémoire résistive. Dans cet exemple, la cellule 300 comprend les mêmes éléments que la cellule 100 de la figure 1, agencés sensiblement de la même manière, et comprend en outre un deuxième transistor d'accès 305, un transistor MOS à canal P dans l'exemple représenté, reliant le noeud n à un noeud supplémentaire DL de la cellule, non connecté au noeud BL. La grille du transistor 305 est connectée à un noeud supplémentaire GL de la cellule, non connecté au noeud WL. Ainsi, dans la cellule 300, un unique élément de stockage à résistance programmable (l'élément 101) est connecté à un noeud commun (le noeud n) à deux transistors d'accès reliés en série (les transistors 103 et 305), cet élément de stockage reliant le noeud commun n à un autre noeud (le noeud SL) de la cellule. On notera que par unique élément de stockage, on entend ici que la cellule ne comprend pas un autre élément de stockage à résistance programmable reliant le noeud n à un noeud de la cellule distinct du noeud SL. Toutefois, l'élément de stockage 101 peut être constitué de plusieurs éléments de stockage de même polarité, identiques ou similaires, connectés en parallèle entre le noeud n et le noeud SL.

La figure 4 est un chronogramme illustrant un exemple d'un procédé de commande de la cellule 300 de la figure 3. Plus particulièrement, la figure 4 illustre l'évolution, en fonction du temps, des potentiels appliqués sur les noeuds SL, BL, WL, DL et GL de la cellule 300 lors de différentes phases de commande de la cellule.

Lors d'une phase d'initialisation (FORM) de la cellule 300, le noeud BL est mis à un potentiel de référence ou masse, par exemple de 0 V, le noeud SL est mis à un potentiel positif V_{FORM}, par exemple supérieur à V_{DD}, par exemple de l'ordre de 2*V_{DD}, et le transistor d'accès 103 de la cellule est rendu passant par application d'un potentiel positif inférieur au potentiel V_{FORM}, par exemple de l'ordre de V_{DD}, sur le noeud WL. Pendant la phase d'initialisation, le transistor 305 est maintenu bloqué. Pour cela, dans cet exemple, les noeuds GL et DL sont tous deux mis à un même potentiel positif, par exemple de l'ordre de V_{DD}.

Lors d'une phase (RESET) de reprogrammation de la cellule 300 dans un état fortement résistif, le noeud SL est mis à la masse, le noeud DL est mis à un potentiel positif V_{RESET}, par exemple supérieur à V_{DD}, par exemple de l'ordre de 1,5*V_{DD}, et le transistor d'accès 305 de la cellule est rendu passant par application d'un potentiel positif inférieur au potentiel V_{RESET}, par exemple un potentiel de l'ordre de V_{DD}/2, sur le noeud GL. Pendant la phase de reprogrammation de la cellule dans un état fortement résistif, le transistor 103 est maintenu bloqué. Pour cela, dans cet exemple, les noeuds BL et WL sont tous deux mis à un même potentiel positif, par exemple de l'ordre de V_{DD}.

Lors d'une phase (SET) de reprogrammation de la cellule 300 dans un état faiblement résistif, le noeud BL est mis à la masse, le noeud SL est mis à un potentiel positif V_{SET}, par exemple de l'ordre de V_{DD}, et le transistor d'accès 103 de la cellule est rendu passant par application d'un potentiel positif, par exemple de l'ordre de V_{DD}, sur le noeud WL. Pendant cette étape, le transistor 305 est maintenu bloqué. Pour cela, dans cet exemple, les noeuds DL et GL sont mis à un même potentiel positif, par exemple de l'ordre de V_{DD}.

Lors d'une phase (READ) de lecture de la cellule 300, le noeud BL est préchargé à un potentiel positif V_{READ1}, par exemple de l'ordre de V_{DD}, puis laissé flottant, et le noeud SL est mis à un potentiel V_{READ2} inférieur au potentiel V_{READ1}, par exemple à un potentiel de l'ordre de V_{DD}/2. Le transistor d'accès 103 de la cellule est alors rendu passant par application d'un potentiel positif, par exemple de l'ordre de V_{DD}, sur le noeud WL. Après un temps de décharge pendant lequel le transistor d'accès 103 est à l'état passant, le potentiel du noeud BL est comparé à un potentiel de référence par un circuit de lecture non représenté. Dans cet exemple, pendant la phase de lecture, le transistor 305 est maintenu bloqué. Pour cela, les noeuds DL et GL sont mis à un même potentiel positif, par exemple de l'ordre de V_{DD}.

Dans cet exemple, pendant des phases (RET) de veille ou de rétention d'information, c'est-à-dire lorsque la mémoire est alimentée mais qu'aucune opération d'initialisation, d'écriture ou de lecture n'est effectuée dans la cellule, les noeuds BL, SL et DL sont mis à un même potentiel, par exemple un potentiel positif de l'ordre de V_{DD}, et les transistors 103 et 305 sont bloqués par l'application de potentiels adaptés sur les noeuds WL et GL, par exemple un potentiel de 0 V sur le noeud WL et un potentiel de l'ordre de V_{DD} sur le noeud GL.

Un avantage de la cellule mémoire 300 réside dans le fait qu'elle comprend deux noeuds BL et DL distincts permettant tous deux d'appliquer des potentiels de commande sur le noeud n, via le transistor 103 pour le noeud BL et via le transistor 305 pour le noeud DL. Ceci permet de simplifier les circuits de commande de la cellule. En particulier, on peut par exemple choisir d'utiliser le noeud BL et le transistor 103 pour appliquer des tensions positives entre les noeuds SL et n (pendant les phases de FORM et de SET dans cet exemple), et d'utiliser le noeud DL et le transistor 305 pour appliquer des tensions négatives entre les noeuds SL et n (pendant les phases de RESET et de READ dans cet exemple). Ceci permet en outre d'améliorer la fiabilité de la cellule et de prolonger sa durée de vie. En effet, la prévision du transistor 305 et du noeud supplémentaire DL permet de mettre en oeuvre des modes de commande dans lesquels les oxydes de grille des transistors 103 et 305 ne sont soumis qu'à des tensions relativement faibles, typiquement inférieures à V_{DD}, ce qui n'est pas possible avec une cellule du type décrit en relation avec la figure 1. Ceci se vérifie tout particulièrement dans le cas représenté en figure 3 dans lequel les transistors 103 et 305 sont de type de conductivité opposés. On peut notamment, lorsque les transistors 103 et 305 sont de types de conductivité opposés, commander la cellule de façon que :
- la différence entre le potentiel appliqué sur le noeud n lors de la phase de programmation de la cellule à l'état fortement résistif et le potentiel appliqué sur le noeud n lors de la phase de programmation de la cellule à l'état faiblement résistif soit supérieure à la tension grille-source ou grille-drain maximale que peuvent supporter sans dégradation les transistors 103 et 305 (par exemple la tension V_{DD}) ; et
- les potentiels appliqués sur les grilles des transistors 103 et 305 lors des phases de programmation de la cellule à l'état fortement résistif et à l'état faiblement résistif soient de niveaux intermédiaires entre le potentiel appliqué sur le noeud n lors de la phase de programmation de la cellule à l'état fortement résistif et le potentiel appliqué sur le noeud n lors de la phase de programmation de la cellule à l'état faiblement résistif.

Plus particulièrement, les potentiels appliqués sur les grilles des transistors 103 et 305 lors des phases de programmation de la cellule à l'état fortement résistif et à l'état faiblement résistif peuvent être choisis de façon que les transistors 103 et 305 ne voient jamais des tensions grille-source ou grille-drain supérieures à la tension grille-source ou grille-drain maximale que peuvent supporter ces transistors sans dégradation. Ceci permet d'augmenter la fiabilité et la durée de vie des transistors d'accès par rapport à une cellule du type décrit en relation avec la figure 1.

De plus, le dimensionnement de chacun des transistors 103 et 305 peut être adapté spécifiquement aux opérations pour lesquelles ce transistor est destiné à être utilisé. En particulier, les transistors 103 et 305 peuvent avoir des largeurs de canal différentes. Ceci permet par exemple d'obtenir, à partir de niveaux de tension identiques, des niveaux de courant différents dans l'élément de stockage selon que le courant passe par le transistor 103 ou par le transistor 305.

On notera que bien que l'on ait représenté en figure 3 un exemple de réalisation dans lequel les transistors 103 et 305 sont de types de conductivité opposés, les modes de réalisation décrits ne se limitent pas à ce cas particulier. A titre de variante, le transistor 305 peut être de même type de conductivité que le transistor 103, par exemple à canal N.

Lorsque les transistors 103 et 305 sont de même type de conductivité, il est tout particulièrement intéressant que ces transistors soient dimensionnés différemment. En effet, pour certains types d'éléments de stockage à résistance programmable, il peut en pratique être nécessaire, pour ne pas endommager l'élément de stockage, que le courant appliqué à l'élément de stockage lors des phases de programmation à l'état faiblement résistif (SET) soit plus faible que le courant appliqué à l'élément de stockage lors des phases de programmation à l'état fortement résistif (RESET). Dans une cellule traditionnelle du type décrit en relation avec la figure 1, ceci rend la commande du transistor 103 relativement complexe. Dans une cellule du type décrit en relation avec la figure 3, le contrôle du courant appliqué à l'élément de stockage peut être obtenu par un dimensionnement adapté des transistors 103 et 305. A titre d'exemple, les transistors 103 et 305 peuvent être dimensionnés de façon que, pour une même tension de commande appliquée sur leurs grilles respectives, le courant circulant dans le transistor 103 soit plus faible que le courant circulant dans le transistor 305. Le transistor 103 peut alors être utilisé pour programmer l'élément de stockage 101 à l'état faiblement résistif (SET), et le transistor 305 peut être utilisé pour programmer l'élément de stockage 101 à l'état fortement résistif (RESET). A titre de variante, les transistors 103 et 305 peuvent tous deux être utilisés pour programmer l'élément de stockage 101 à l'état faiblement résistif, mais avec des valeurs de résistance différentes (ce qui permet de stocker plus d'un bit de données par élément de stockage). Par exemple, le transistor 305 peut être utilisé pour programmer l'élément 101 à l'état fortement résistif (RESET) et pour programmer l'élément 101 à un premier état faiblement résistif (SET1), et le transistor 103 peut être utilisé pour programmer l'élément 101 à un deuxième état faiblement résistif (SET2), plus fortement résistif que le premier état.

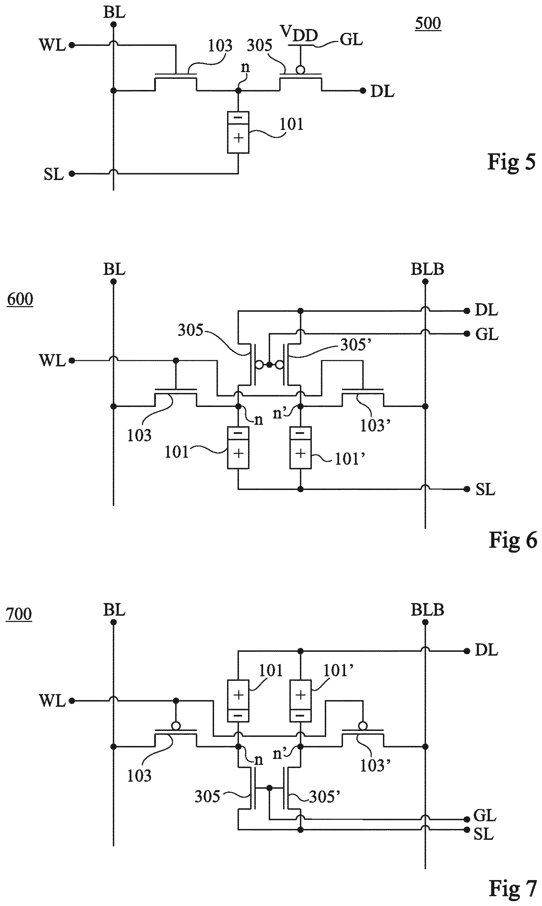

La figure 5 est un schéma électrique illustrant une variante de réalisation de la cellule 300 de la figure 3. La cellule 500 de la figure 5 diffère de la cellule 300 en ce que, dans l'exemple de la figure 5, le noeud GL est connecté à un noeud ou rail d'application d'un potentiel fixe ou constant V_{C}, égal au potentiel V_{DD} dans cet exemple. Dans l'exemple de la figure 5, le signal appliqué sur le noeud DL est transmis ou bloqué par le transistor 305 en fonction de sa valeur. En particulier, le transistor 305 est passant lorsque le potentiel du noeud DL est supérieur à V_{C} + VT, où VT désigne la tension de seuil du transistor 305, et bloqué lorsque le potentiel du noeud DL est inférieur à V_{C} + VT. Un avantage de cette variante de réalisation est que la cellule 500 comprend un noeud de commande de moins que dans l'exemple de la figure 3, ce qui simplifie la réalisation des circuits de commande de la mémoire.

La cellule 500 de la figure 5 peut par exemple être commandée selon un procédé similaire à celui décrit en relation avec la figure 4. A titre d'exemple, le procédé de commande de la cellule 500 diffère du procédé de la figure 4 uniquement par le mode de commande du transistor 305. En particulier, lors des phases d'initialisation (FORM) de la cellule, de reprogrammation de la cellule dans un état faiblement résistif (SET), de lecture (READ) et de veille (RET), le transistor 305 peut être maintenu bloqué en appliquant sur le noeud DL un potentiel positif inférieur à V_{C} + VT, par exemple un potentiel de l'ordre de V_{DD}. Lors des phases de reprogrammation de la cellule dans un état fortement résistif (RESET), le transistor 305 peut être rendu passant en appliquant sur le noeud DL un potentiel positif supérieur à V_{C} + VT, par exemple un potentiel de l'ordre de 1,5*V_{DD}.

Dans le cas où le transistor 305 est un transistor à canal N, le potentiel fixe V_{C} appliqué sur la grille du transistor 305 est par exemple égal au potentiel de masse, par exemple 0 V.

La figure 6 est un schéma électrique illustrant une variante de réalisation différentielle de la cellule 300 de la figure 3. La cellule 600 de la figure 6 comprend les mêmes éléments que la cellule 300 de la figure 3, connectés sensiblement de la même manière, et comprend en outre, un deuxième élément de stockage 101' à résistance programmable, par exemple identique ou similaire à l'élément 101, et des troisième et quatrième transistors d'accès 103' et 305', par exemple respectivement identiques ou similaires aux transistors 103 et 305. Le transistor 103' est connecté en série avec l'élément de stockage 101' entre un noeud BLB de la cellule 600 (non connecté aux noeuds BL et DL) et le noeud SL. Dans cet exemple, les électrodes de l'élément de stockage 101' sont connectées respectivement au noeud SL et à un noeud intermédiaire n' (non connecté au noeud n) de la cellule 600, et les noeuds de conduction (source, drain) du transistor 103' sont connectés respectivement au noeud n' et au noeud BLB. La grille du transistor 103' est connectée au noeud WL. Les électrodes de conduction du transistor 305' sont connectées respectivement au noeud n' et au noeud DL. La grille du transistor 305' est connectée au noeud GL. Ainsi, dans la cellule 600, un unique élément de stockage à résistance programmable (l'élément 101') est connecté à un noeud commun (le noeud n') à deux transistors d'accès reliés en série (les transistors 103' et 305'), cet élément de stockage reliant le noeud commun n' à un autre noeud (le noeud SL) de la cellule. On notera que par unique élément de stockage, on entend ici que la cellule ne comprend pas un autre élément de stockage à résistance programmable reliant le noeud n' à un noeud de la cellule distinct du noeud SL. Toutefois, l'élément de stockage 101' peut être constitué de plusieurs éléments de stockage de même polarité, identiques ou similaires, connectés en parallèle entre le noeud n' et le noeud SL. Dans cet exemple, on considère que l'élément de stockage 101' de la cellule 600 est connecté de telle façon que la programmation de l'élément 101' dans un état faiblement résistif soit obtenu par application d'une tension positive entre les noeuds SL et n' de la cellule, et que la programmation de l'élément 101' dans un état fortement résistif soit obtenu par application d'une tension négative entre les noeuds SL et n' de la cellule.

La cellule 600 est adaptée à stocker une information de façon différentielle, c'est-à-dire que lorsque l'élément de stockage 101 est programmé dans un état fortement résistif, l'élément de stockage 101' est programmé dans un état faiblement résistif, et lorsque l'élément de stockage 101 est programmé dans un état faiblement résistif, l'élément de stockage 101' est programmé dans un état fortement résistif. Ceci permet une lecture plus aisée et plus fiable de la valeur stockée dans la cellule.

A titre d'exemple, lors d'une phase d'initialisation (FORM) de la cellule 600, les noeuds BL et BLB sont tous les deux mis à la masse, le noeud SL est mis au potentiel V_{FORM}, et les transistors 103 et 103' de la cellule sont tous deux rendus passants par application d'un potentiel adapté (par exemple de l'ordre de V_{DD}) sur le noeud WL. Pendant la phase d'initialisation, les transistors 305 et 305' peuvent être maintenus bloqués, par exemple en appliquant un même potentiel positif (par exemple de l'ordre de V_{DD}) sur les noeuds GL et DL.

Lors d'une phase (RESET) de reprogrammation de la cellule 600 dans un état fortement résistif, le noeud SL peut être mis à la masse, le noeud DL peut être mis au potentiel positif V_{RESET}, et les transistors d'accès 305 et 305' de la cellule peuvent être rendus passant par application d'un potentiel positif inférieur au potentiel V_{RESET} sur le noeud GL (par exemple un potentiel de l'ordre de V_{DD}/2). Pendant la phase de reprogrammation de la cellule dans un état fortement résistif, les transistors 103 et 103' peuvent être maintenus bloqués, par exemple par application d'un même potentiel positif sur les noeuds BL, BLB et WL, par exemple un potentiel de l'ordre de V_{DD}.

Lors d'une phase (SET) de reprogrammation de la cellule 600 dans un état faiblement résistif, les noeuds BL et BLB peuvent être mis à la masse, le noeud SL peut être mis au potentiel positif V_{SET}, et les transistors d'accès 103 et 103' de la cellule peuvent être rendus passants par application d'un potentiel positif (par exemple de l'ordre de V_{DD}) sur le noeud WL. Pendant cette étape, les transistors 305 et 305' peuvent être maintenus bloqués, par exemple par application d'un même potentiel positif, par exemple de l'ordre de V_{DD}, sur les noeuds DL et GL.

Pour écrire une donnée de façon différentielle dans la cellule 600, on peut d'abord prévoir de reprogrammer la cellule dans un état fortement résistif comme indiqué ci-dessus (phase de RESET). Le noeud SL peut ensuite être mis au potentiel positif V_{SET}, et l'un des noeuds BL et BLB peut être mis à la masse et l'autre au potentiel V_{SET}, Les transistors 103 et 103' peuvent alors être rendus passants par application d'un potentiel positif, par exemple de l'ordre de V_{DD}, sur le noeud WL. Si le noeud BL est à la masse et le noeud BLB au potentiel V_{SET}, l'élément de stockage 101 passera à l'état faiblement résistif et l'élément de stockage 101' restera à l'état fortement résistif. Inversement, si le noeud BLB est à la masse et le noeud BL au potentiel V_{SET}, l'élément de stockage 101' passera à l'état faiblement résistif et l'élément de stockage 101 restera à l'état fortement résistif. Pendant cette étape, les transistors 305 et 305' peuvent être maintenus bloqués, par exemple par application d'un même potentiel positif, par exemple de l'ordre de V_{DD}, sur les noeuds DL et GL.

Lors d'une phase (READ) de lecture d'une donnée mémorisée de façon différentielle dans la cellule 600, les noeuds BL et BLB peuvent être préchargés à un même potentiel positif V_{READ1} (par exemple de l'ordre de V_{DD}) puis laissés flottants, et le noeud SL peut être mis à un potentiel V_{READ2} inférieur au potentiel V_{READ1} (par exemple un potentiel de l'ordre de V_{DD}/2). Les transistors d'accès 103 et 103' de la cellule sont alors rendus passants par application d'un potentiel positif, par exemple de l'ordre de V_{DD}, sur le noeud WL. Après un temps de décharge pendant lequel les transistors 103 et 103' sont à l'état passant, un circuit de lecture non représenté détermine si la tension entre les noeuds BL et BLB est positive ou négative, ce qui permet de connaître la valeur stockée dans la cellule. Dans cet exemple, pendant la phase de lecture, les transistors 305 et 305' peuvent être maintenus bloqués, par exemple par application d'un potentiel positif (par exemple de l'ordre de V_{DD}) sur le noeud GL.

Pendant les phases (RET) de veille ou de rétention d'information, c'est-à-dire lorsque la mémoire est alimentée mais qu'aucune opération d'initialisation, d'écriture ou de lecture n'est effectuée dans la cellule, les noeuds BL, BLB, SL et DL peuvent être mis à un même potentiel, par exemple un potentiel positif (par exemple de l'ordre de V_{DD}), et les transistors 103, 103', 305 et 305' peuvent être bloqués par l'application de potentiels adaptés sur les noeuds WL et GL.

A titre de variante, dans l'exemple de la figure 6, le noeud GL peut, comme dans l'exemple de la figure 5, être connecté à un noeud d'application d'un potentiel d'alimentation haute constant, par exemple le potentiel V_{DD}. Dans ce cas, la commande des transistors 305 et 305' s'effectue via le noeud DL, de façon similaire à ce qui a été décrit en relation avec la figure 5.

La figure 7 est un schéma électrique illustrant une variante de réalisation d'une cellule mémoire différentielle. La cellule 700 de la figure 7 correspond sensiblement au complémentaire de la cellule 600 de la figure 6. Dans la cellule 700 de la figure 7, l'élément 101 est connecté entre les noeuds n et DL de telle façon que la programmation de l'élément 101 dans un état faiblement résistif soit obtenu par application d'une tension positive entre les noeuds DL et n, et que la programmation de l'élément 101 dans un état fortement résistif soit obtenu par application d'une tension négative entre les noeuds DL et n. De plus, dans cet exemple, l'élément 101' est connecté entre les noeuds n' et DL de telle façon que la programmation de l'élément 101' dans un état faiblement résistif soit obtenu par application d'une tension positive entre les noeuds DL et n', et que la programmation de l'élément 101' dans un état fortement résistif soit obtenu par application d'une tension négative entre les noeuds DL et n'. Dans cet exemple, les transistors 103 et 103' sont des transistors MOS à canal P, et sont connectés respectivement entre les noeuds n et BL et entre les noeuds n' et BLB. Les grilles des transistors 103 et 103' sont connectées au noeud WL. Dans cet exemple, les transistors 305 et 305' sont des transistors MOS à canal N, et sont connectés respectivement entre les noeuds n et SL et entre les noeuds n' et SL. Les grilles des transistors 305 et 305' sont connectées au noeud GL.

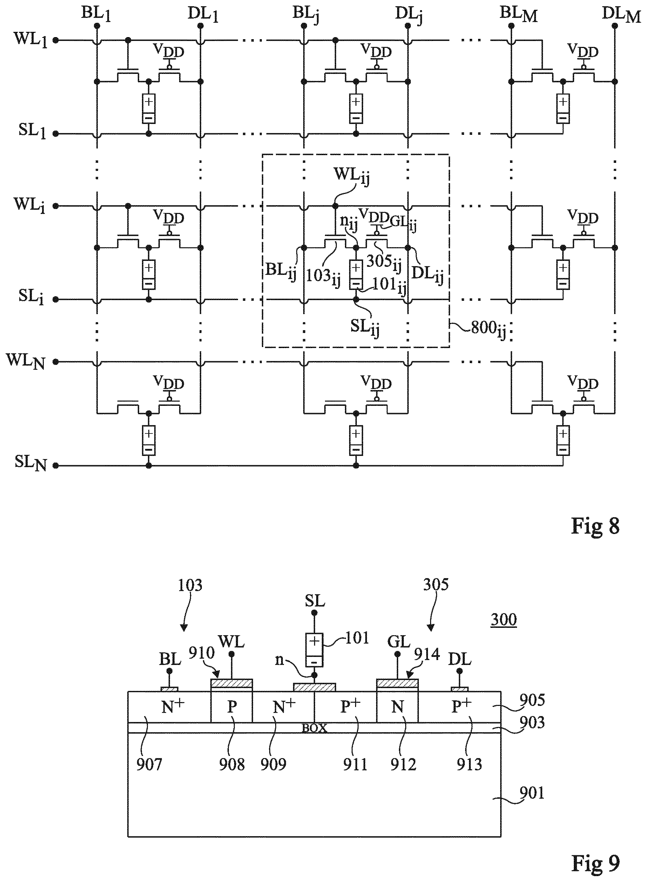

La figure 8 est un schéma électrique illustrant un exemple d'un mode de réalisation d'une mémoire résistive. La mémoire de la figure 8 comprend une matrice de N*M cellules mémoire 800ᵢⱼ identiques ou similaires disposées en N lignes et M colonnes, avec N et M entiers supérieurs à 1, i entier allant de 1 à N (indice de ligne) et j entier allant de 1 à M (indice de colonne). Dans cet exemple, chaque cellule 800ᵢⱼ comprend un élément de stockage 101ᵢⱼ à résistance programmable, connecté entre des noeuds SLᵢⱼ et nᵢⱼ de la cellule. Dans cet exemple, l'élément 101ᵢⱼ est connecté de telle façon que la programmation de l'élément 101ᵢⱼ dans un état faiblement résistif soit obtenu par application d'une tension négative entre les noeuds SLᵢⱼ et nᵢⱼ, et que la programmation de l'élément 101ᵢⱼ dans un état fortement résistif soit obtenu par application d'une tension positive entre les noeuds SLᵢⱼ et nᵢⱼ. Chaque cellule 800ᵢⱼ comprend en outre un transistor MOS 103ᵢⱼ, un transistor à canal N dans l'exemple représenté, connecté entre le noeud nᵢⱼ et un noeud BLᵢⱼ de la cellule. La grille du transistor 103ᵢⱼ est connectée à un noeud WLᵢⱼ de la cellule. Chaque cellule 800ᵢⱼ comprend de plus un transistor MOS 305ᵢⱼ, un transistor à canal P dans cet exemple, connecté entre le noeud nᵢⱼ et un noeud DLᵢⱼ de la cellule distinct du noeud BLᵢⱼ. La grille du transistor 305ᵢⱼ est connectée à un noeud GLᵢⱼ de la cellule. Dans cet exemple, dans chaque cellule élémentaire 800ᵢⱼ, le noeud GLᵢⱼ de la cellule est connecté à un noeud d'application d'un potentiel d'alimentation haute constant, le potentiel V_{DD} dans l'exemple représenté.

Dans cet exemple, l'initialisation (FORM) d'une cellule 800ᵢⱼ peut être effectuée par l'intermédiaire du transistor 305ᵢⱼ, en mettant les noeuds SLᵢⱼ et DLᵢⱼ de la cellule respectivement à la masse et au potentiel V_{FORM} (V_{FORM} étant supérieur à V_{DD}+VT pour provoquer la mise en conduction du transistor 305ᵢⱼ). La reprogrammation de la cellule dans un état fortement résistif (RESET) peut être effectuée par l'intermédiaire du transistor 103ᵢⱼ, en mettant les noeuds SLᵢⱼ et BLᵢⱼ respectivement au potentiel V_{RESET} et à la masse, et le noeud WLᵢⱼ à un potentiel de commande à l'état passant du transistor 103ᵢⱼ. La reprogrammation de la cellule dans un état faiblement résistif (SET) peut être effectuée par l'intermédiaire du transistor 305ᵢⱼ, en mettant les noeuds SLᵢⱼ et DLᵢⱼ de la cellule respectivement à la masse et au potentiel V_{SET} (V_{SET} étant supérieur à V_{DD}+VT pour provoquer la mise en conduction du transistor 305ᵢⱼ). La lecture (READ) de la cellule peut être effectuée par l'intermédiaire du transistor 103ᵢⱼ, en mettant les noeuds SLᵢⱼ et BLᵢⱼ respectivement au potentiel V_{READ1} et au potentiel V_{READ2}, et le noeud WLᵢⱼ à un potentiel de commande à l'état passant du transistor 103ᵢⱼ.

Dans cet exemple, les noeuds BLᵢⱼ des cellules 800ᵢⱼ d'une même colonne de rang j de la matrice sont connectés par une piste conductrice BLⱼ, les noeuds DLᵢⱼ des cellules 800ᵢⱼ d'une même colonne de rang j de la matrice sont connectés par une piste conductrice DLⱼ, les noeuds WLᵢⱼ des cellules 800ᵢⱼ d'une même ligne de rang i de la matrice sont connectés par une piste conductrice WLᵢ, et les noeuds SLᵢⱼ des cellules 800ᵢⱼ d'une même ligne de rang i de la matrice sont connectés par une piste conductrice SLᵢ.

Les phases de FORM et de SET peuvent être effectuées selon trois types de granularité, à savoir par cellule, par groupe de plusieurs cellules d'une même ligne de la matrice, ou par groupe de plusieurs cellules situées aux intersections d'un ensemble de plusieurs lignes et de plusieurs colonnes de la matrice.

A titre d'exemple, pour initialiser (FORM) individuellement une cellule 800ᵢⱼ, la piste SLᵢ peut être mise à la masse, les autres pistes SL peuvent être mises au potentiel V_{FORM}, la piste DLⱼ peut être mise au potentiel V_{FORM}, et les autres pistes DL peuvent être mises à un potentiel permettant de bloquer les transistors MOS 305 correspondants, par exemple au potentiel V_{DD}. Lors de cette opération, les transistors 103 de toutes les cellules de la matrice peuvent être maintenus bloqués, par exemple par application d'un même potentiel positif (par exemple le potentiel V_{DD}) sur toutes les pistes BL et WL de la mémoire. La reprogrammation (SET) de la cellule dans un état faiblement résistif peut être effectuée de façon similaire, en remplaçant le potentiel V_{FORM} par le potentiel V_{SET}.

Pour initialiser (FORM) ou reprogrammer dans un état faiblement résistif (SET) simultanément plusieurs cellules d'une même ligne de rang i de la mémoire, la piste SLᵢ peut être mise à la masse, les autres pistes SL peuvent être mises au potentiel positif V_{FORM} ou V_{SET} (selon l'opération que l'on souhaite effectuer), les pistes DL des colonnes que l'on souhaite activer peuvent être mises au potentiel positif V_{FORM} ou V_{SET}, et les autres pistes DL peuvent être mises à un potentiel permettant de bloquer les transistors MOS 305 correspondants, par exemple au potentiel V_{DD}.

Pour initialiser (FORM) ou reprogrammer dans un état faiblement résistif (SET) simultanément les cellules situées aux intersections d'un ensemble de plusieurs lignes et plusieurs colonnes de la mémoire, les pistes SL des lignes à activer peuvent être mises à la masse, et les autres pistes SL peuvent être mises au potentiel positif V_{FORM} ou V_{SET} (selon l'opération que l'on souhaite effectuer), les pistes DL des colonnes à activer peuvent être mises au potentiel V_{FORM} ou V_{SET}, et les autres pistes DL peuvent être mises à un potentiel permettant de bloquer les transistors MOS 305 correspondants, par exemple au potentiel V_{DD}.

Les phases de RESET peuvent être effectuées selon les trois types de granularité susmentionnés, à savoir par cellule, par groupe de plusieurs cellules d'une même ligne, ou par groupe de plusieurs cellules situées aux intersections d'un ensemble de plusieurs lignes et d'un ensemble de plusieurs colonnes.

A titre d'exemple, pour reprogrammer individuellement une cellule 800ᵢⱼ dans un état fortement résistif (RESET), la piste SLᵢ peut être mise au potentiel positif V_{RESET}, la piste BLⱼ peut être mise à la masse, et la piste WLᵢ peut être mise à un potentiel de commande à l'état passant du transistor 103ᵢⱼ, par exemple le potentiel V_{DD}. Les autres pistes SL peuvent être mises à la masse, et les autres pistes BL et WL peuvent être mises à un même potentiel positif, par exemple le potentiel V_{DD}, de façon à bloquer les transistors 103 correspondants. Lors de cette opération, les transistors 305 de toutes les cellules de la matrice peuvent être maintenus bloqués, par exemple par application d'un potentiel positif de l'ordre de V_{DD} sur toutes les pistes DL de la mémoire.

Pour reprogrammer dans un état fortement résistif (RESET) simultanément plusieurs cellules d'une même ligne de rang i de la mémoire, la piste SLᵢ peut être mise au potentiel V_{RESET}, les pistes BL des colonnes à activer peuvent être mises à la masse, et la piste WLᵢ peut être mise à un potentiel de commande à l'état passant du transistor 103ᵢⱼ, par exemple le potentiel V_{DD}. Les autres pistes SL peuvent être mises à la masse, et les autres pistes BL et WL peuvent être mises à un même potentiel positif, par exemple le potentiel VDD, de façon à bloquer les transistors 103 correspondants. Les transistors 305 de toutes les cellules de la matrice peuvent être maintenus bloqués, par exemple par application d'un potentiel positif de l'ordre de V_{DD} sur toutes les pistes DL de la mémoire.

Pour reprogrammer dans un état fortement résistif (RESET) simultanément les cellules situées aux intersections d'un ensemble de plusieurs lignes et plusieurs colonnes de la mémoire, les pistes SL des lignes à activer peuvent être mises au potentiel V_{RESET}, les pistes BL des colonnes à activer peuvent être mises à la masse, et les pistes WL des lignes à activer peuvent être mises à un potentiel de commande à l'état passant des transistors 103 correspondants, par exemple au potentiel V_{DD}. Les autres pistes SL peuvent être mises à la masse, et les autres pistes BL et WL peuvent être mises à un même potentiel positif, par exemple le potentiel VDD, de façon à bloquer les transistors 103 correspondants. Les transistors 305 de toutes les cellules de la matrice peuvent être maintenus bloqués, par exemple par application d'un potentiel positif de l'ordre de V_{DD} sur toutes les pistes DL de la mémoire.

Les phases de lecture (READ) peuvent être effectuées selon deux types de granularité, à savoir par cellule, ou par groupe de plusieurs cellules d'une même ligne, avec des sens de polarisations identiques à ceux des phases de reprogrammation dans un état fortement résistif (RESET).

La figure 9 est une vue en coupe illustrant de façon schématique un exemple de réalisation d'une cellule mémoire 300 du type décrit en relation avec la figure 3. Dans cet exemple, la cellule 300 est réalisée dans et sur un substrat de type semiconducteur sur isolant (SOI), comportant un empilement d'un support semiconducteur 901, par exemple en silicium, d'une couche isolante 903 (BOX), par exemple en oxyde de silicium, et d'une couche semiconductrice 905, par exemple en silicium. Les transistors 103 et 305 sont formés dans et sur la couche semiconductrice 905. Plus particulièrement, le transistor 103 comprend deux régions 907 et 909 dopées de type N (N⁺), séparées par une région 908 dopée de type P, les régions 907, 908 et 909 étant formées dans la couche 905, et la région 908 étant surmontée d'un empilement de grille 910. Le transistor 305 comprend deux régions 911 et 913 dopées de type P (P⁺), séparées par une région 912 dopée de type N, les régions 911, 912 et 913 étant formées dans la couche 903, et la région 912 étant surmontée d'un empilement de grille 914. Dans cet exemple, les régions 909 et 911 sont juxtaposées et reliées par une métallisation formée du côté de leur face supérieure (c'est-à-dire opposée à la couche 905), connectant les régions 909 et 911 au noeud n de la cellule. Une métallisation formée du côté de la face supérieure de la région 907 connecte la région 907 au noeud BL de la cellule, et une métallisation formée du côté de la face supérieure de la région 913 connecte la région 913 au noeud DL de la cellule. Les grilles 910 et 914 sont respectivement connectées au noeud WL et au noeud GL. L'élément de stockage à résistance programmable 101 est formé dans les couches supérieures (non représentées) de la structure, entre le noeud n et le noeud SL.

La structure de la figure 9 présente l'avantage d'être particulièrement compacte, notamment du fait de la juxtaposition des transistors 103 et 305 et de la disposition de l'élément de stockage 101 dans l'espace situé au-dessus des transistors 103 et 305. Les modes de réalisation décrits ne se limitent toutefois pas à cet agencement particulier.

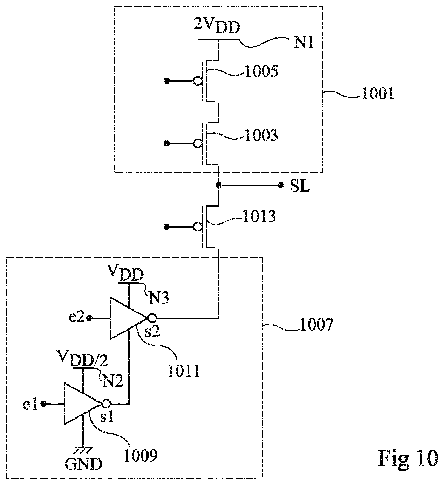

La figure 10 est un schéma électrique partiel d'un exemple de réalisation d'un circuit de commande adapté à fournir les différents potentiels de commande d'une cellule mémoire du type décrit en relation avec les figures 3 à 9. Plus particulièrement, la figure 10 représente un circuit adapté à fournir les différents niveaux de potentiel de commande à appliquer sur le noeud SL d'une cellule mémoire résistive du type décrit en relation avec les figures 3 et 4. Le circuit de la figure 10 comprend un étage haute tension 1001 destiné à fournir un potentiel supérieur à V_{DD} (notamment le potentiel V_{FORM} dans l'exemple de la figure 4). Dans cet exemple, l'étage 1001 comporte deux transistors MOS à canal P 1003 et 1005 en série entre le noeud SL et un noeud N1 d'application d'un potentiel positif constant supérieur à V_{DD}, de l'ordre de 2*V_{DD} dans cet exemple. A titre de variante, pour avoir le choix entre plusieurs potentiels compris entre V_{DD} et 2*V_{DD}, plusieurs ensembles de transistors cascodés peuvent être connectés en parallèle entre le noeud SL et le noeud N1. Le circuit de la figure 10 comprend en outre un étage basse tension 1007 destiné à fournir des potentiels compris dans la plage allant du potentiel GND, ou potentiel de masse, au potentiel V_{DD} (notamment les potentiels V_{SET} et V_{READ2} dans l'exemple de la figure 4). Dans cet exemple, l'étage 1007 comporte un premier inverseur 1009 dont un noeud d'alimentation basse est connecté à la masse et dont un noeud d'alimentation haute est connecté à un noeud N2 d'application d'un premier potentiel positif constant inférieur ou égal à V_{DD}, de l'ordre de V_{DD}/2 dans cet exemple. Dans cet exemple, l'étage 1007 comporte en outre un deuxième inverseur 1011 dont un noeud d'alimentation basse est connecté à un noeud s1 de sortie de l'inverseur 1009 et dont un noeud d'alimentation haute est connecté à un noeud N3 d'application d'un deuxième potentiel positif constant inférieur ou égal à V_{DD} et supérieur au premier potentiel, de l'ordre de V_{DD} dans cet exemple. Un noeud d'entrée e1 de l'inverseur 1009 est adapté à recevoir un potentiel de commande compris entre le potentiel GND et le potentiel V_{DD}, et un noeud d'entrée e2 de l'inverseur 1011 est adapté à recevoir un potentiel de commande compris entre le potentiel GND et le potentiel V_{DD}. Un noeud de sortie s2 de l'inverseur 1011 est relié au noeud SL par un transistor MOS à canal N 1013 permettant de déconnecter l'étage basse tension 1007 du noeud SL lorsqu'un potentiel supérieur à V_{DD} est appliqué sur le noeud SL par l'étage haute tension 1001.

Des modes de réalisation particuliers ont été décrits. Diverses variantes et modifications apparaîtront à l'homme de l'art.

En particulier, à partir des exemples décrits ci-dessus, l'homme de l'art saura prévoir d'autres configurations de cellules élémentaires, notamment en inversant la polarité des éléments de stockage, et/ou en modifiant les types de conductivité des transistors MOS.

De plus, bien que l'on ait décrit ci-dessus uniquement des exemples de procédé de commande dans lesquels les phases de lecture (READ) des cellules résistives sont des lectures en tension, il apparaîtra à l'homme de l'art que les cellules décrites ci-dessus sont compatibles avec une lecture en courant (c'est-à-dire une lecture dans laquelle, pour déterminer l'état de résistivité de l'élément de stockage, on applique une tension fixe aux bornes de l'élément de stockage, et on mesure le courant circulant dans l'élément de stockage).

Plus généralement, les modes de réalisation décrits ne se limitent pas aux exemples de procédés de commande décrits ci-dessus.

En outre, les modes de réalisation décrits ne se limitent pas à l'exemple particulier de schéma d'interconnexion des cellules élémentaires décrit en relation avec la figure 8.

Par ailleurs, divers modes de réalisation avec diverses variantes ont été décrits ci-dessus. L'homme de l'art pourra combiner divers éléments de ces divers modes de réalisation et variantes sans faire preuve d'activité inventive.

## Revendications

1. Mémoire non volatile à résistance programmable comprenant une pluralité de cellules élémentaires (300 ; 500 ; 600 ; 700 ; 800) disposées en lignes et en colonnes, chaque cellule comportant :
un premier transistor d'accès (103) reliant des premier (n) et deuxième (BL) noeuds de la cellule ;
un deuxième transistor d'accès (305) reliant le premier noeud (n) à un troisième noeud (DL ; SL) de la cellule ; et
un unique élément de stockage (101) à résistance programmable connecté au premier noeud (n), cet élément de stockage (101) reliant le premier noeud (n) à un quatrième noeud (SL ; DL) de la cellule,
dans laquelle, dans chaque ligne, les cellules ont leurs quatrièmes noeuds (SL ; DL) connectés par une première piste conductrice (SLᵢ) de connexion en ligne, et les grilles de leurs premiers transistors (103) connectées par une deuxième piste conductrice (WLᵢⱼ) de connexion en ligne, et dans laquelle, dans chaque colonne, les cellules ont leurs deuxièmes noeuds (BL) connectés par une première piste conductrice (BLⱼ) de connexion en colonne, et leurs troisièmes noeuds (DL ; SL) connectés par une deuxième piste conductrice (DLⱼ) de connexion en colonne,
la mémoire comportant en outre un circuit de commande connecté aux cellules par l'intermédiaire des premières (SLᵢ) et deuxièmes (WLᵢⱼ) pistes conductrices de connexion en ligne et des premières (BLⱼ) et deuxièmes (DLⱼ) pistes conductrices de connexion en colonne, ce circuit étant adapté à :
lors d'une phase de programmation d'une cellule dans un premier état, maintenir le deuxième transistor (305) de la cellule bloqué et appliquer une tension d'une première polarité aux bornes de l'élément de stockage (101) de la cellule par l'intermédiaire des quatrième (SL ; DL) et deuxième (BL) noeuds et du premier transistor (103) de la cellule ; et
lors d'une phase de programmation de la cellule dans un deuxième état, maintenir le premier transistor (103) de la cellule bloqué et appliquer une tension de polarité opposée aux bornes de l'élément de stockage (101) de la cellule par l'intermédiaire des quatrième (SL ; DL) et troisième (DL ; SL) noeuds et du deuxième transistor (305) de la cellule,
dans laquelle les premier (103) et deuxième (305) transistors sont des transistors MOS de types de conductivité opposés et/ou de dimensions différentes.

2. Mémoire selon la revendication 1, dans laquelle le circuit de commande est en outre adapté, lors d'une phase de lecture d'une cellule à : précharger le deuxième noeud (BL) de la cellule à un premier potentiel (V_{READ1}) ; appliquer un deuxième potentiel (V_{READ2}) inférieur au premier potentiel sur le quatrième noeud (SL ; DL) de la cellule ; commander à l'état passant le premier transistor (103) ; puis comparer le potentiel du deuxième noeud (BL) à un potentiel de référence.

3. Mémoire selon la revendication 1 ou 2, dans laquelle, dans chaque cellule (500 ; 800), la grille du deuxième transistor (305) est connectée à un noeud d'application d'un potentiel fixe.

4. Mémoire selon l'une quelconque des revendications 1 à 3, dans laquelle, dans chaque cellule :
les premier (103) et deuxième (305) transistors sont des transistors MOS de types de conductivité opposés ;
la différence entre le potentiel appliqué sur le premier noeud (n) lors la phase de programmation de la cellule dans le premier état et le potentiel appliqué sur le premier noeud (n) lors la phase de programmation de la cellule dans le deuxième état est supérieure à la tension grille-source ou grille-drain maximale que peuvent supporter sans dégradation les premier (103) et deuxième (305) transistor ; et
les potentiels appliqués sur les grilles des premier (103) et deuxième (305) transistors lors des phases de programmation de la cellule dans les premier et deuxième états sont de niveau intermédiaire entre le potentiel appliqué sur le premier noeud (n) lors la phase de programmation de la cellule dans le premier état et le potentiel appliqué sur le premier noeud (n) lors la phase de programmation de la cellule dans le deuxième état.

5. Mémoire selon l'une quelconque des revendications 1 à 4, dans laquelle, dans chaque cellule (300 ; 500 ; 600 ; 700 ; 800), le premier transistor (103) est un transistor MOS à canal N, et le deuxième transistor (305) est un transistor MOS à canal P.

6. Mémoire selon l'une quelconque des revendications 1 à 5, dans laquelle chaque cellule (600 ; 700) comprend en outre :
un troisième transistor d'accès (103') reliant un cinquième noeud (n') à un sixième noeud (BLB) de la cellule ;
un quatrième transistor d'accès (305') reliant le cinquième noeud (n') au troisième noeud (DL ; SL) de la cellule ; et
un unique élément de stockage (101') à résistance programmable connecté au cinquième noeud (n'), cet élément de stockage reliant le cinquième noeud au quatrième noeud (SL ; DL) de la cellule.

7. Mémoire selon la revendication 6, dans laquelle, dans chaque cellule (600 ; 700), la grille du troisième transistor (103') est connectée à la grille du premier transistor (103), et la grille du quatrième transistor (305') est connectée à la grille du deuxième transistor (305).

8. Mémoire selon la revendication 6 ou 7, dans laquelle, dans chaque cellule, les premier (103) et troisième (103') transistors sont de même type de conductivité, et les deuxième (305) et quatrième (305') transistors sont de même type de conductivité.

## Patentansprüche

1. Ein Nichtflüchtiger Speicher mit programmierbarem Widerstand, der eine Vielzahl von Elementarzellen (300; 500; 600; 700; 800) aufweist, die in Reihen und Spalten angeordnet sind, wobei jede Zelle Folgendes aufweist:
einen ersten Zugriffstransistor (103), der einen ersten (n) und zweiten (BL) Knoten der Zelle verbindet;
einen zweiten Zugriffstransistor (305), der den ersten Knoten (n) mit einem dritten Knoten (DL; SL) der Zelle verbindet; und
ein einzelnes Speicherelement mit programmierbarem Widerstand (101), das mit dem ersten Knoten (n) verbunden ist, wobei dieses Speicherelement (101) den ersten Knoten (n) mit einem vierten Knoten (SL; DL) der Zelle verbindet,
wobei in jeder Reihe die Zellen ihre vierten Knoten (SL; DL) durch eine erste reihenverbindende leitende Bahn (SLᵢ) verbunden haben, und die Gates ihrer ersten Transistoren (103) durch eine zweite reihenverbindende leitende Bahn (WLᵢⱼ) verbunden sind, und wobei in jeder Spalte die Zellen ihre zweiten Knoten (BL) durch eine erste reihenverbindende leitende Bahn (BLⱼ) und ihre dritten Knoten (DL; SL) durch eine zweite spaltenverbindende leitende Bahn (DLⱼ) verbunden haben,
wobei der Speicher ferner eine Steuerschaltung aufweist, die mit den Zellen über die ersten (SLᵢ) und zweiten (WLᵢⱼ) reihenverbindenden leitenden Bahnen und die ersten (BLⱼ) und zweiten (DLⱼ) spaltenverbindenden leitenden Bahnen verbunden ist, wobei diese Schaltung für Folgendes konfiguriert ist:
während einer Phase des Programmierens einer Zelle in einen ersten Zustand, Halten des zweiten Transistors (305) der Zelle in einem ausgeschalteten Zustand und Anlegen einer Spannung einer ersten Vorspannung über das Speicherelement (101) der Zelle über den vierten (SL; DL) und zweiten (BL) Knoten und den ersten Transistor (103) der Zelle; und
während einer Phase des Programmierens der Zelle in einen zweiten Zustand, Halten des ersten Transistors (103) der Zelle in einem ausgeschalteten Zustand und Anlegen einer Spannung mit einer entgegengesetzten Vorspannung über das Speicherelement (101) der Zelle über den vierten (SL; DL) und dritten (DL; SL) Knoten und den zweiten Transistor (305) der Zelle,
wobei der erste (103) und zweite (305) Transistor MOS-Transistoren mit entgegengesetzten Leitfähigkeitstypen und/oder mit unterschiedlichen Abmessungen sind.

2. Der Speicher nach Anspruch 1, wobei die Steuerschaltung, während einer Phase des Lesens einer Zelle ferner zu Folgendem in der Lage ist: Vorladen des zweiten Knotens (BL) der Zelle auf eine erste Spannung (V_{READ1}), Anlegen einer zweiten Spannung (V_{READ2}) an den vierten Knoten (SL; DL) der Zelle, die niedriger ist als die erste Spannung; Steuern des ersten Transistors (103) in den eingeschalteten Zustand; und dann Vergleichen der Spannung des zweiten Knotens (BL) mit einer Referenzspannung.

3. Der Speicher nach Anspruch 1 oder 2, wobei in jeder Zelle (500; 800) das Gate des zweiten Transistors (305) mit einem Knoten zum Anlegen einer festen Spannung verbunden ist.

4. Der Speicher nach einem der Ansprüche 1 bis 3, wobei in jeder Zelle:
die ersten (103) und zweiten (305) Transistoren MOS-Transistoren mit entgegengesetzter Leitfähigkeit sind;
die Differenz zwischen der Spannung, die an den ersten Knoten (n) während der Phase der Programmierung der Zelle in den ersten Zustand angelegt wird, und der Spannung, die an den ersten Knoten (n) während der Phase der Programmierung der Zelle in den zweiten Zustand angelegt wird, größer ist als die maximale Gate-Source-Spannung oder Gate-Drain-Spannung, der der erste (103) und zweite (305) Transistor widerstehen können, ohne beschädigt zu werden; und
die Spannungen, die an die Gates des ersten (103) und zweiten (305) Transistors während der Phasen der Programmierung der Zelle in den ersten und zweiten Zustand angelegt werden, ein Zwischenniveau haben zwischen der Spannung, die an den ersten Knoten (n) während der Phase der Programmierung der Zelle in den ersten Zustand angelegt wird, und der Spannung, die an den ersten Knoten (n) während der Phase der Programmierung der Zelle in den zweiten Zustand angelegt wird.

5. Der Speicher nach einem der Ansprüche 1 bis 4, wobei in jeder Zelle (300; 500; 600; 700; 800) der erste Transistor (103) ein N-Kanal-MOS-Transistor ist und der zweite Transistor (305) ein P-Kanal-MOS-Transistor ist.

6. Der Speicher nach einem der Ansprüche 1 bis 5, wobei jede Zelle (600; 700) ferner Folgendes aufweist:
einen dritten Zugriffstransistor (103'), der einen fünften Knoten (n') mit einem sechsten Knoten (BLB) der Zelle koppelt;
einen vierten Zugriffstransistor (305'), der den fünften Knoten (n') mit dem dritten Knoten (DL; SL) der Zelle koppelt; und
ein einzelnes Speicherelement mit programmierbarem Widerstand (101'), das mit dem fünften Knoten (n') verbunden ist, wobei dieses Speicherelement den fünften Knoten mit dem vierten Knoten (SL; DL) der Zelle verbindet.

7. Der Speicher nach Anspruch 6, wobei in jeder Zelle (600; 700) das Gate des dritten Transistors (103') mit dem Gate des ersten Transistors (103) und das Gate des vierten Transistors (305') mit dem Gate des zweiten Transistors (305) verbunden ist.

8. Der Speicher nach Anspruch 6 oder 7, wobei in jeder Zelle der erste (103) und dritte (103') Transistor vom gleichen Leitfähigkeitstyp sind und der zweite (305) und vierte (305') Transistor vom gleichen Leitfähigkeitstyp sind.

## Claims

1. A programmable-resistance non-volatile memory comprising a plurality of elementary cells (300; 500; 600; 700; 800) arranged in rows and in columns, each cell comprising:
a first access transistor (103) coupling first (n) and second (BL) nodes of the cell;
a second access transistor (305) coupling the first node (n) to a third node (DL; SL) of the cell; and
a single programmable-resistance storage element (101) connected to the first node (n), this storage element (101) coupling the first node (n) to a fourth node (SL; DL) of the cell,
wherein, in each row, the cells have their fourth nodes (SL; DL) connected by a first row-connection conductive track (SLᵢ), and the gates of their first transistors (103) connected by a second row-connection conductive track (WLᵢⱼ), and wherein, in each column, the cells have their second nodes (BL) connected by a first column-connection conductive track (BLⱼ) and their third nodes (DL; SL) connected by a second column-connection conductive track (DLⱼ),
the memory further comprising a control circuit connected to the cells via the first (SLᵢ) and second (WLᵢⱼ) row-connection conductive tracks and the first (BLⱼ) and second (DLⱼ) column-connection conductive tracks, this circuit being configured for:
during a phase of programming a cell to a first state, maintaining the second transistor (305) of the cell off and applying a voltage of a first biasing across the storage element (101) of the cell via the fourth (SL; DL) and second (BL) nodes and the first transistor (103) of the cell; and
during a phase of programming the cell to a second state, maintaining the first transistor (103) of the cell off and applying a voltage having an opposite biasing across the storage element (101) of the cell via the fourth (SL; DL) and third (DL; SL) nodes and the second transistor (305) of the cell,
wherein the first (103) and second (305) transistors are MOS transistors of opposite conductivity types and/or of different dimensions.

2. The memory of claim 1, wherein the control circuit is further capable, during a phase of reading a cell, of: precharging the second node (BL) of the cell to a first voltage (V_{READ1}); applying a second voltage (V_{READ2}) lower than the first voltage to the fourth node (SL; DL) of the cell; controlling the first transistor (103) to the on state; and then comparing the voltage of the second node (BL) with a reference voltage.

3. The memory of claim 1 or 2, wherein, in each cell (500; 800), the gate of the second transistor (305) is connected to a node of application of a fixed voltage.

4. The memory of any of claims 1 to 3, wherein, in each cell:
the first (103) and second (305) transistors are MOS transistors of opposite conductivity types;
the difference between the voltage applied to the first node (n) during the phase of programming the cell to the first state and the voltage applied to the first node (n) during the phase of programming the cell to the second state is greater than the maximum gate-source or gate-drain voltage that the first (103) and second (305) transistors can withstand without being damaged; and
the voltages applied to the gates of the first (103) and second (305) transistors during phases of programming the cell to the first and second states have an intermediate level between the voltage applied to the first node (n) during the phase of programming the cell to the first state and the voltage applied to the first node (n) during the phase of programming the cell to the second state.

5. The memory of any of claims 1 to 4, wherein, in each cell (300; 500; 600; 700; 800), the first transistor (103) is an N-channel MOS transistor, and the second transistor (305) is a P-channel MOS transistor.

6. The memory of any of claims 1 to 5, wherein each cell (600; 700) further comprises:
a third access transistor (103') coupling a fifth node (n') to a sixth node (BLB) of the cell;
a fourth access transistor (305') coupling the fifth node (n') to the third node (DL; SL) of the cell; and
a single programmable-resistance storage element (101') connected to the fifth node (n'), this storage element coupling the fifth node to the fourth node (SL; DL) of the cell.

7. The memory of claim 6, wherein, in each cell (600; 700), the gate of the third transistor (103') is connected to the gate of the first transistor (103), and the gate of the fourth transistor (305') is connected to the gate of the second transistor (305).

8. The memory of claim 6 or 7, wherein, in each cell, the first (103) and third (103') transistors are of the same conductivity type, and the second (305) and fourth (305') transistors are of the same conductivity type.
